(19) Europäisches Patentamt
European Patent Office
Office européen des brevets

(11) EP 2 816 697 B1

(12) **EUROPEAN PATENT SPECIFICATION**

(45) Date of publication and mention
of the grant of the patent:
**07.06.2017  Bulletin 2017/23**

(51) Int Cl.:
***H02J 3/01*** *(2006.01)*

(21) Application number: **14173258.6**

(22) Date of filing: **20.06.2014**

(54) **Systems and method for selecting circuit element values for a hybrid active power filter operating over a variable frequency**

Systeme und Verfahren zur Auswahl von Schaltungselementwerten für einen hybriden, aktiven Leistungsfilter mit einer variablen Frequenz

Systèmes et procédé de sélection de valeurs d'élément de circuit pour un filtre de puissance actif hybride fonctionnant sur une fréquence variable

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.06.2013  US 201313923708**

(43) Date of publication of application:
**24.12.2014  Bulletin 2014/52**

(73) Proprietor: **Hamilton Sundstrand Corporation**
**Charlotte, NC 28217 (US)**

(72) Inventor: **Rodriguez, Fernando**
**Manchester, CT 06042 (US)**

(74) Representative: **Hughes, Andrea Michelle**
**Dehns**
**St Bride's House**
**10 Salisbury Square**
**London EC4Y 8JD (GB)**

(56) References cited:
- **WIROJ TANGTHEERAJAROONWONG ET AL: "Design and Performance of a Transformerless Shunt Hybrid Filter Integrated Into a Three-Phase Diode Rectifier", IEEE TRANSACTIONS ON POWER ELECTRONICS, INSTITUTE OF ELECTRICAL AND ELECTRONICS ENGINEERS, USA, vol. 22, no. 5, 1 September 2007 (2007-09-01), pages 1882-1889, XP011191735, ISSN: 0885-8993, DOI: 10.1109/TPEL.2007.904166**
- **DATABASE WPI Week 200802 Thomson Scientific, London, GB; AN 2008-A19981 XP002731398, -& CN 200 976 497 Y (SHANDONG SHANDA HUATIAN SCI & TECHNOLOGY) 14 November 2007 (2007-11-14)**

**Description**

<u>Field</u>

The present teachings relate to systems and methods for selecting circuit element values for a hybrid active power filter operating over a variable frequency, and more particularly, to platforms and techniques for identifying necessary values of circuit components to permit a hybrid active power filter to operate over a desired variable frequency range.

<u>Background</u>

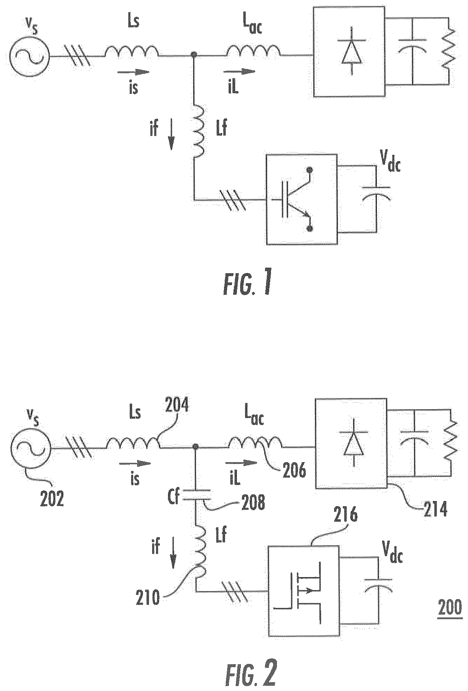

In the field of power systems, it has been known to connect a rectifier to an alternating current (AC) power source to derive a direct current (DC) for motors or other loads. A rectifier connected to a 3-phase AC voltage source, however, generates undesired current harmonics, namely the 5th, 7th, 11th, 13th, 17th, 19th, 23rd, and 25th harmonics, which can introduce noise and other artifacts in the power circuit.
To address that undesirable harmonic content, it has been known to use a shunt active power filter, as shown in FIG. 1. A shunt active power filter, however suffers from the drawback of requiring a high dc link voltage (Vdc > Vs, peak), as well as a high switching frequency.
A hybrid active power filter can also be used to eliminate the undesirable harmonics, with the added benefit of using a lower dc link voltage (0.15*Vs, peak < Vdc < 0.35Vs, peak). In a HAPF circuit, the lower voltage is made possible because the filter capacitor (Cf) acts to block the fundamental voltage component. Use of an HAPF has been demonstrated and documented for fixed frequencies (50 and 60Hz) in known designs.
Nevertheless, the application of an HAPF system to a variable frequency system has not been demonstrated. In an HAPF system designed to operate on source voltages which are variable, such as between 360-800 Hz, the selection of the values for constituent capacitors and filter inductors becomes important to ensure reliable and effective operation.
WIROJ TANGTHEERAJAROONWONG ET AL: "Design and Performance of a Transformerless Shunt Hybrid Filter Integrated Into a Three-Phase Diode Rectifier", IEEE TRANSACTIONS ON POWER ELECTRONICS, INSTITUTE OF ELECTRICAL AND ELECTRONICS ENGINEERS, USA, vol. 22, no. 5, 1 September 2007 (2007-09-01), pages 1882-1889, XP011191735, ISSN: 0885-8993, DOI: 10.1109/TPEL.2007.904166 describes a hybrid active power filter and its design parameters for a fixed frequency of 50 Hz.

<u>DESCRIPTION OF DRAWINGS</u>

The accompanying drawings, which are incorporated in and constitute a part of this specification, illustrate embodiments of the present teachings and together with the description, serve to explain the principles of the present teachings. In the figures:

FIG. 1 illustrates an exemplary shunt active power filter, according to known implementations;
FIG. 2 illustrates an exemplary HAPF circuit, according to various embodiments of the present teachings; a
FIG. 3 illustrates a graph of harmonic amplitudes versus AC impedance (Lac) values, according to various embodiments; and
FIG. 4 illustrates a graph of filter impedance versus current in various logarithmic ranges, according to various embodiments of the present teachings.

<u>DESCRIPTION OF EMBODIMENTS</u>

Embodiments of the present teachings relate to systems and methods for selecting circuit element values for a hybrid active power filter operating over a variable frequency. More particularly, embodiments relate to platforms and techniques for identifying or selecting capacitor and inductor values which permit the suppression of undesired harmonics, even while operating over a significant range of variable input frequency.
Reference will now be made in detail to exemplary embodiments of the present teachings, which are illustrated in the accompanying drawings. Where possible the same reference numbers will be used throughout the drawings to refer to the same or like parts.
FIG. 2 illustrates an exemplary HAPF circuit 200 in which systems and methods for selecting circuit element values for a hybrid active power filter operating over a variable frequency can operate, according to aspects. In aspects as shown, the HAPF circuit 200 can contain a voltage source 202, which can be or include an AC current source. In implementations, the voltage source 202 can be a three-phase current source. In implementations, the current source can be configured to provide an AC power signal over a range of AC frequencies.

The HAPF circuit 200 can likewise include an inductor 204 through which a source current flows, which is delivered to remaining elements of the HAPF circuit 200. In one branch of the circuit topology, a portion of the source current (iL) can be delivered to an inductor 206 and a network 214. The inductor 206 can function to provide an inductive load on the portion of the incoming AC source current which is delivered to the network 214. In implementations as shown, the network 214 can contain a diode element as well as a parallel capacitor-resistor network.

In aspects, a portion of the source current (if) can also be delivered to a set of other circuit elements including capacitor 208, inductor 210, and network 216. In implementations as shown, the network 216 can include a transistor or other switching element, along with a capacitor across which the DC voltage output of the HAPF circuit 200 is delivered. According to aspects, the present teachings provide an analytical method for calculating the values of capacitor 208 (labeled Cf) and inductor 210 (labeled Lf) in the HAPF 200, to permit satisfactory operation over a source frequency range of at least 360Hz - 800Hz, or others. One objective of that analysis is to choose the values of the inductor 206 (labeled Lac) inductor 210, and capacitor 208 to inject harmonics while using 200V MOSFET transistor elements (Vs can be 400VLL). In instances where the exact type or design of inductor 206 is available, then that information can be used to set the harmonic amplitudes. In instances where that information is not known, for a given inductor 206, the harmonic values can be located through analytical expressions or simulation.

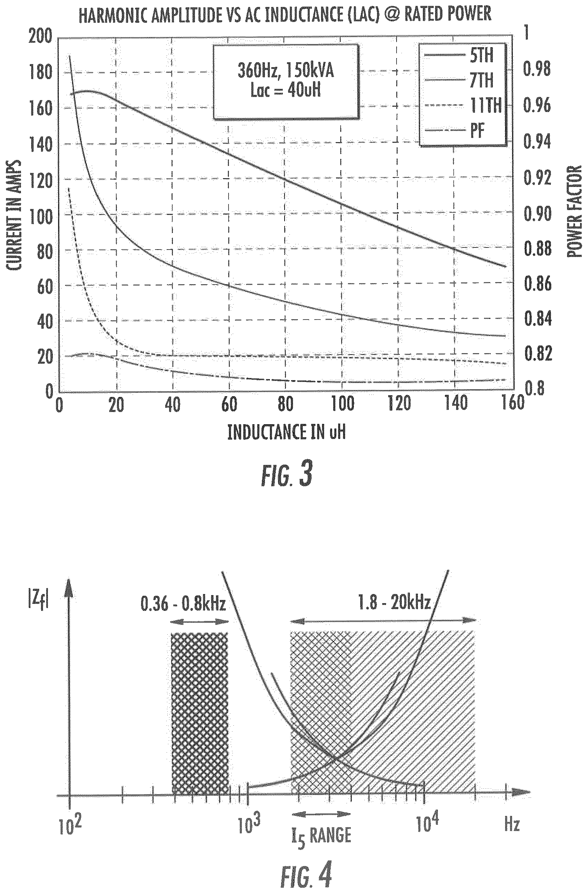

More particularly, the analysis can start with a value for the inductor 206. That value determines the amplitude of undesired harmonics. In particular, a higher value of inductance for the inductor 206 results in a lower value for harmonic current values, as for instance shown in FIG. 3. The value for the amplitudes of harmonic currents at the fifth harmonic frequencies (5*3601-Hz - 5*800Hz) are known via simulation, as again shown in FIG. 3.

With those parameters established, according to aspects, the choice of capacitance value for capacitor 208 and inductance value for inductor 210 must result in the following properties:

- a small reactive fundamental current (block fundamental current component)
- a low |Zf ($\omega$)| to allow for current harmonic injection with 200V MOSFETS; and
- since the 5th harmonic current has greatest magnitude, the |Zf ($\omega$)| must be low over the 5th harmonic when the frequency varies from 360-800Hz. A graph of this further condition is illustrated, for instance, in FIG. 4.

With those conditions in view, the following quantities can be determined. Equations 1-3 are used to calculate the value of the capacitance value of capacitor 208 and the inductance value of inductor 210. Equations 4 and 5 are a result of equations 1 - 3, and Equations 4 and 5 can be re-arranged to produce Equations 6 and 7. Equations 6 and 7 can be used to explicitly solve for the values of the capacitor 208 and inductor 210. It may be noted that Equations 6 and 7 assume a resonant frequency between 5*360 and 5*800 Hz, reflecting the fifth harmonic of the source current caused by the network 214. The resulting values allow the HAPF to satisfactory reduce all harmonics of interest, including the 5th, 7th, 11th, 13th, 17th, 19th, 23rd, 25th harmonics, over the entire illustrative target range of 360 - 800 Hz.

- Equations 1-3 used to calculate Cf and Lf

$$\left|Z_{f,s}\right| = \left|L_f \omega_s - \frac{1}{C_f \omega_s}\right| \qquad (1)$$

$$\left|Z_{f,s}\right| \le \frac{V_{dc}}{2} m \cdot \frac{1}{I_s} \qquad (2)$$

$$\left|L_f \omega_s - \frac{1}{C_f \omega_s}\right| \le \frac{V_{dc}}{2} m \frac{1}{I_s} \qquad (3)$$

- If we constrain $1/\left(2\pi\sqrt{L_f C_f}\right)$ to be between 5*360Hz and 5*800Hz, then from equations 1-3, 4 & 5 result

$$\left|L_f \omega_{s,360} - \frac{1}{C_f \omega_{s,360}}\right| = \frac{1}{C_f \omega_{s,360}} - L_f \omega_{s,360} \le \frac{V_{dc}}{2} m \frac{1}{I_{s,360}} \qquad (4)$$

$$\left| L_f \omega_{5,800} - \frac{1}{C_f \omega_{5,800}} \right| = L_f \omega_{5,800} - \frac{1}{C_f \omega_{5,800}} \le \frac{V_{dc}}{2} m \frac{1}{I_{5,800}} \qquad (5)$$

- Re-arrange 4 & 5 and solve for $L_f$ and $C_f$ in equations 6 & 7

$$L_f \omega_{5,800} - \frac{1}{C_f \omega_{5,800}} - \frac{V_{dc}}{2} m \frac{1}{I_{5,800}} \le 0 \qquad (6)$$

$$\frac{1}{C_f \omega_{5,360}} - L_f \omega_{5,360} - \frac{V_{dc}}{2} m \frac{1}{I_{5,360}} \le 0 \qquad (7)$$

---

Variable definitions

$Z_{f,5}$: 5th harmonic filer impedance

$L_5$: filter inductance

$C_5$: filter capacitance

$\omega_5$: 5th harmonic frequency

$V_{dc}$: dc link voltage

m: modulation index (-0.9)

$I_5$: 5th harmonic current amplitude

$\omega_{5,360}$: 5th harmonic frequency with 360Hz fundamental

$\omega_{5,800}$: 5th harmonic frequency with 800Hz fundamental

$I_{5,360}$: 5th harmonic current amplitude with 360Hz fundamental

$I_{5,800}$: 5th harmonic current amplitude with 800Hz fundamental

---

The foregoing description is illustrative, and variations in configuration and implementation may occur to persons skilled in the art. For example, while embodiments have been described in which a single network 214 and single network 216 are provided in the HAPF circuit 200, in implementations, multiple networks providing similar circuit functionality can be provided. Other resources described as singular or integrated can in embodiments be plural or distributed, and resources described as multiple or distributed can in embodiments be combined. Other circuit elements or topologies can be used in the HAPF circuit 200 to provide filtered power while adhering to the same approach to selection of capacitive and inductive values described above. The scope of the present teachings is accordingly intended to be limited only by the following claims.

**Claims**

1. A method of generating circuit element values in a hybrid active power filter operable in the range of 360-800Hz; wherein the filter is adapted to receive a source alternating current and comprises a first capacitor (208), a first inductor (210) and a first filter network (216) serially connected, through which a first portion of the source alternating current flows, wherein the first filter network includes a switching element along with a second capacitor across which a dc link voltage is delivered; wherein the filter further comprises a second inductor (206) and a second filter network (214) serially connected, through which a second portion of the source alternating current flows; said method comprising:

   determining a value of an inductive load provided on the second portion of the source alternating current delivered to the second filter network;
   identifying a variable frequency range of the source alternating current;
   determining amplitudes of a set of current harmonics related to the source alternating current over the variable frequency range for the determined value of the inductive load;
   generating at least an inductor value and a capacitor value for the filter based on an impedance of the filter configured to reduce the amplitudes of the set of current harmonics; and wherein
   generating at least the inductor value and the capacitor value comprises solving:

$$L_f\,\omega_{5,800} - \frac{1}{C_f\,\omega_{5,800}} - \frac{V_{dc}}{2}m\,\frac{1}{I_{5,800}} \le 0\ ;$$

and

$$\frac{1}{C_f\,\omega_{5,360}} - L_f\,\omega_{5,360} - \frac{V_{dc}}{2}m\,\frac{1}{I_{5,360}} \le 0\ ,$$

where

$L_f$ is the inductor value of the first inductor, $C_f$ is the capacitor value of the first capacitor, $\omega_{5,800}$ is the 5th harmonic frequency with 800 Hz fundamental, $I_{5,800}$ is the 5th harmonic current amplitude with 800 Hz fundamental, $\omega_{5,360}$ is the 5th harmonic frequency with 360 Hz fundamental, $I_{5,360}$ is the 5th harmonic current amplitude with 360 Hz fundamental, $V_{dc}$ is the dc link voltage, and m is a modulation index of the first filter network.

2. The method of claim 1, wherein the set of current harmonics related to the source alternating current comprises at least a set of 5th, 7th, 11th, 19th, 23rd, and 25 harmonics.

3. The method of claim 1, wherein the impedance of the filter is selected to allow use of metal oxide semiconductor field effect transistors (MOSFETs) for current harmonic injection at a rated voltage.

4. The method of claim 3, wherein the MOSFETs rated voltage is 200 V.

5. The method of claim 1, wherein determining the value of the inductive load comprises performing a simulation.

6. The method of claim 1, wherein determining the amplitude of the set of current harmonics comprises performing a simulation.

**Patentansprüche**

1. Verfahren zum Erzeugen von Schaltungselementwerten in einem hybriden Aktivleistungsfilter, das im Bereich von 360-800 Hz betriebsfähig ist; wobei das Filter zum Empfangen eines Quellenwechselstroms angepasst ist und einen ersten Kondensator (208), einen ersten Induktor (210) und ein erstes Filternetzwerk (216) umfasst, die in Reihe verbunden sind, durch die ein erster Teil des Quellenwechselstroms fließt, wobei das erste Filternetzwerk ein Schaltelement zusammen mit einem zweiten Kondensator beinhaltet, über das eine Zwischenkreisspannung zugeführt wird; wobei das Filter weiter einen zweiten Induktor (206) und ein zweites Filternetzwerk (214) umfasst, die in Reihe verbunden sind, durch die ein zweiter Teil des Quellenwechselstroms fließt;
wobei das Verfahren Folgendes umfasst:

Bestimmen eines Werts einer induktiven Last, die am zweiten Teil des Quellenwechselstroms bereitgestellt ist, der dem zweiten Filternetzwerk zugeführt wird;
Identifizieren eines variablen Frequenzbereichs des Quellenwechselstroms;
Bestimmen von Amplituden eines Satzes Stromoberschwingungen in Bezug auf den Quellenwechselstrom über den variablen Frequenzbereich für den bestimmten Wert der induktiven Last;
Erzeugen mindestens eines Induktorwerts und eines Kondensatorwerts für das Filter auf der Grundlage einer Impedanz des Filters, der dazu konfiguriert ist, die Amplituden des Satzes Stromoberschwingungen zu reduzieren; und wobei
Erzeugen mindestens des Induktorwerts und des Kondensatorwerts das Lösen von Folgendem umfasst:

$$L_f\,\omega_{5,800} - \frac{1}{C_f\,\omega_{5,800}} - \frac{V_{dc}}{2}m\,\frac{1}{I_{5,800}} \le 0\ ;$$

und

$$\frac{1}{C_f \, \omega_{5,360}} - L_f \, \omega_{5,360} - \frac{V_{dc}}{2} m \, \frac{1}{I_{5,360}} \leq 0 \quad,$$

wobei

$L_f$ der Induktorwert des ersten Induktors ist, $C_f$ der Kondensatorwert des ersten Kondensators ist, $\omega_{5,800}$ die 5. harmonische Frequenz mit 800 Hz Grundfrequenz ist, $I_{5,800}$ die 5. harmonische Stromamplitude mit 800 Hz Grundfrequenz ist, $\omega_{5,360}$ die 5. harmonische Frequenz mit 360 Hz Grundfrequenz ist, $I_{5,360}$ die 5. harmonische Stromamplitude mit 360 Hz Grundfrequenz ist, $V_{dc}$ die Zwischenkreisspannung und m ein Modulationsindex des ersten Filternetzwerks ist.

2. Verfahren nach Anspruch 1, wobei der Satz Stromoberschwingungen in Bezug auf den Quellenwechselstrom mindestens einen Satz 5., 7., 11., 19., 23. und 25 Oberwellen umfasst.

3. Verfahren nach Anspruch 1, wobei die Impedanz des Filters ausgewählt ist, um eine Verwendung von Metall-Oxid-Halbleiter-Feldeffekttransistoren (MOSFETs) für eine Stromoberwelleneinspeisung bei einer Nennspannung zu ermöglichen.

4. Verfahren nach Anspruch 3, wobei die Nennspannung der MOSFETs 200 V beträgt.

5. Verfahren nach Anspruch 1, wobei Bestimmen des Werts der induktiven Last ein Durchführen einer Simulation umfasst.

6. Verfahren nach Anspruch 1, wobei Bestimmen der Amplitude des Satzes Stromoberschwingungen ein Durchführen einer Simulation umfasst.

## Revendications

1. Procédé de production de valeurs d'élément de circuit dans un filtre hybride de puissance active fonctionnant dans la fourchette de 360 à 800 Hz ; dans lequel le filtre est conçu pour recevoir une source de courant alternatif et comprend un premier condensateur (208), un premier inducteur (210) et un premier réseau de filtres (216) connectés en série, à travers lequel passe une première partie du courant alternatif source, dans lequel le premier réseau de filtres comprend un élément de commutation accompagné d'un second condensateur à travers lequel une tension de liaison de courant continu est délivrée ; dans lequel le filtre comprend également un second inducteur (206) et un second réseau de filtres (214) connectés en série, à travers lequel passe une seconde partie du courant alternatif source ;
ledit procédé comprenant :

la détermination d'une valeur d'une charge inductive fournie à la seconde partie du courant alternatif source délivré au second réseau de filtres ;
l'identification d'une fourchette de fréquence variable du courant alternatif source ;
la détermination des amplitudes d'un jeu des harmoniques de courant apparenté à la source de courant alternatif sur la fourchette de fréquence variable pour la valeur déterminée de la charge inductive ;
la production d'au moins une valeur d'inducteur et d'une valeur de condensateur pour le filtre basé sur une impédance du filtre configurée pour réduire les amplitudes du jeu des harmoniques de courant ; et dans lequel la production de l'au moins une valeur d'inducteur et de la valeur de condensateur comprend la résolution de :

$$L_f \, \omega_{5,800} - \frac{1}{C_f \, \omega_{5,800}} - \frac{V_{dc}}{2} m \, \frac{1}{I_{5,800}} \leq 0 \quad ;$$

et

$$\frac{1}{C_f \, \omega_{5,360}} - L_f \, \omega_{5,360} - \frac{V_{dc}}{2} m \, \frac{1}{I_{5,360}} \leq 0 \quad,$$

dans laquelle

L$_f$ représente la valeur d'inducteur pour le premier inducteur, C$_f$ représente la valeur de condensateur pour le premier condensateur, $\omega_{5800}$ est la 5$^e$ fréquence harmonique avec une fréquence fondamentale de 800 Hz, I$_{5800}$ est la 5$^e$ amplitude de courant harmonique avec une fréquence fondamentale de 800 Hz, $\omega_{5360}$ est la 5$^e$ fréquence harmonique avec une fréquence fondamentale de 360 Hz, I$_{5360}$ est la 5$^e$ amplitude de courant harmonique avec une fréquence fondamentale de 360 Hz, V$_{dc}$ est la tension de liaison de courant continu, et m est un indice de modulation du premier réseau de filtres.

2. Procédé de la revendication 1, dans lequel le jeu des harmoniques de courant apparenté au courant alternatif source comprend au moins un jeu de 5$^e$, 7$^e$, 11$^e$, 19$^e$, 23$^e$ et 25$^e$ harmoniques.

3. Procédé de la revendication 1, dans lequel l'impédance du filtre est choisie pour permettre l'utilisation de transistors à effet de champ à oxydes métalliques (MOSFET) pour l'injection d'harmoniques de courant à une tension définie.

4. Procédé de la revendication 3, dans lequel la tension définie par les MOSFET est de 200 V.

5. Procédé de la revendication 1, dans lequel la détermination de la valeur de la charge inductive comprend la réalisation d'une simulation.

6. Procédé de la revendication 1, dans lequel la détermination de l'amplitude du jeu des harmoniques de courant comprend la réalisation d'une simulation.

FIG. 1

FIG. 2

HARMONIC AMPLITUDE VS AC INDUCTANCE (LAC) @ RATED POWER

FIG. 3

FIG. 4

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Design and Performance of a Transformerless Shunt Hybrid Filter Integrated Into a Three-Phase Diode Rectifier. **WIROJ TANGTHEERAJAROONWONG et al.** IEEE TRANSACTIONS ON POWER ELECTRONICS. INSTITUTE OF ELECTRICAL AND ELECTRONICS ENGINEERS, 01 September 2007, vol. 22, 1882-1889